# EUROPÄISCHE PATENTSCHRIFT

(11) **EP 0 834 482 B1**
(45) Veröffentlichungstag und Bekanntmachung des Hinweises auf die Patenterteilung: **19.12.2001**
(21) Anmeldenummer: 97116713.5
(22) Anmeldetag: 25.09.1997
(51) Int. Cl.: C03C 17/36, C03C 23/00, C23C 14/58

(54) **Verfahren zur Herstellung wärmereflektierender Schichtsysteme**
Process for the production of heat reflecting coating systems
Procédé pour la production des revêtements réflechissant le rayonnement thermique

(30) Priorität: 02.10.1996 DE 19640832
(43) Veröffentlichungstag der Anmeldung: 08.04.1998
(73) Patentinhaber: Arcon Flachglas-Veredelungs GmbH & Co. Beschichtungstechnik KG, 91555 Feuchtwangen (DE)
(72) Erfinder: Söder, Bernhard, Dr., 91639 Wolframs-Eschenbach (DE); Meier, Andreas, 72793 Pfullingen (DE); Schneider, Siegfried, 01445 Radebeul (DE); Hartung, Ullrich Dr., 01129 Dresden (DE); Kirchhoff, Volker, 01324 Dresden (DE)

(56) Entgegenhaltungen:
- EP-A- 0 010 971
- GB-A- 1 285 744
- US-A- 3 515 587
- US-A- 3 694 337
- PATENT ABSTRACTS OF JAPAN vol. 008, no. 178 (C-238), 16.August 1984 & JP 59 074279 A (TOYODA CHUO KENKYUSHO KK), 26.April 1984,
- PATENT ABSTRACTS OF JAPAN vol. 013, no. 479 (C-648), 18.Oktober 1989 & JP 01 188446 A (NIPPON SHEET GLASS CO LTD), 27.Juli 1989,

## Beschreibung

Die Erfindung betrifft ein Verfahren zur Herstellung wärmereflektierender Schichtsysteme auf transparenten Substraten, vorzugsweise auf Flachglas, durch Vakuumzerstäuben (Sputtern). Derartige Schichtsysteme müssen ein hohe Transparenz im sichtbaren Spektralbereich haben. Je nach Anwendungszweck sollen sie einen möglichst großen Teil des Spektrums durchlassen und einen möglichst hohen Anteil der wesentlich niederenergetischeren Raumwärmestrahlung reflektieren bzw. möglichst alle Strahlung mit einer Wellenlänge oberhalb des sichtbaren Bereichs reflektieren. Derartige Schichtsysteme wirken so als Wärmedämmung und werden vorzugsweise bei der Architekturverglasung eingesetzt.

Die eigentliche wärmereflektierende Schicht ist im wesentlichen aus einem Edelmetall, wie z.B. Silber, da sie ein niedriges Emissionsvermögen (typischerweise e ≤ 0,1) des Schichtsystems gewährleistet. Ein Hauptziel bei der Entwicklung derartiger Schichtsysteme bzw. bei der Weiterentwicklung von Verfahren zu deren Herstellung war stets, den ohmschen Flächenwiderstand und damit das Emissionsvermögen zu verringern, und das unter Beibehaltung oder Anhebung der möglichst hohen Transmission im sichtbaren Bereich und Bewahrung der weitestgehenden Farbneutralität der sichtbaren Transmission und Reflexion.

Es ist bekannt, zur Verringerung des Emissionsvermögens durch eine nachträgliche Temperaturbehandlung der beschichteten Scheibe eine spezielle Modifizierung der Wärmebehandlung, die beim Härten oder Biegen von Gläsern verwendet wird, vorzunehmen. Dabei wird die Glasscheibe einer Temperaturbelastung bis zu 670 °C unterworfen (US 4 894 290).

Es ist auch bekannt, zur Verringerung des Emissionsvermögens eine spezielle Temperaturbehandlung der beschichteten Scheibe derart durchzuführen, daß die Scheiben auf 250...450 °C erwärmt werden (DE 44 12 318).

Beiden Verfahren haftet der Mangel an, daß durch die Wärmebehandlung Veränderungen im Schichtsystem erfolgen, die die optischen Eigenschaften negativ beeinflussen.

Ein weiterer Nachteil dieser Verfahren besteht darin, daß durch die zusätzliche, nachträgliche Temperaturbehandlung die Effektivität der Fertigung sinkt. Außerdem können diese Verfahren nur bei temperaturbelastbaren Substraten angewendet werden.

Es ist weiterhin bekannt, beschichtete Substrate, insbesondere Gegenstände während und nach dem Beschichten einer Nachbehandlung mit lonenstrahlen zu unterziehen (JA-A-57185246; EP 0 010 971 A2). Durch diese Nachbehandlung wird eine Veränderung der Schichteigenschaften bewirkt, die jedoch wenig Einfluss auf optische oder elektrische Eigenschaften derselben hat.

Es ist weiterhin bekannt, eine auf Glas aufgestäubte Ni/Cu-Schicht einer oxidierenden Plasmabehandlung zu unterziehen, um eine dielektrische Oxidschicht zu erzeugen (US-A-3,694,337). Dieses Verfahren dient der Herstellung von Metalloxidschichten, wobei dadurch wenig Einfluss auf die optischen und elektrischen Eigenschaften erfolgt. Es wird aus einer Metallschicht eine Oxidschicht erzeugt, indem das Metall durch das Plasma in Verbindung mit einem reaktiven Gas auf das Metall einwirkt.

Der Erfindung liegt die Aufgabe zugrunde, ein Verfahren zur Herstellung wärmereflektierender Schichtsysteme auf transparenten Substraten durch Sputtem zu schaffen, bei dem durch Anpassung bzw. Änderung der Prozeßbedingungen, ggf. durch Einführung eines zusätzl i-chen Prozeßschrittes, nach dem Aufbringen der letzten Schicht des Schichtsystems das Emissionsvermögen unter Beibehaltung oder Anhebung der Transmission im sichtbaren Bereich verringert ist. Insbesondere sollen die beschichteten Substrate keiner anschließenden bzw. nachträglichen Behandlung unterworfen werden.

Erfindungsgemäß wird die Aufgabe nach den Merkmalen des Patentanspruches 1 gelöst. Weitere vorteilhafte Ausgestaltungen des Verfahrens sind in den Unteransprüchen 2 bis 10 beschrieben.

Es wurde gefunden, daß sich überraschenderweise die Emission bei Erhöhung der Transmission im sichtbaren Bereich beim Aufstäuben eines an sich bekannten Schichtsystems vom Aufbau - dielektrische Grundschicht - Edelmetallschicht - dielektrische Deckschicht - wesentlich verringert, wenn während des Sputterprozesses zu dem eigentlichen Beschichtungsplasma ein zusätzliches Plasma auf das teilweise abgeschiedene Schichtsystem, d.h. auf die einzelnen Schichten, mindestens einmal einwirkt entsprechend dem Verfahren nach Anspruch 1. Es wird nach dem Aufstäuben mindestens einer Schicht das zusätzliche Plasma zur Einwirkung gebracht. Es wurde festgestellt, daß abhängig von der Intensität dieser Plasmabehandlung eine Verbesserung des ohmschen Flächenwiderstandes eintritt. Die dazu erforderliche Plasmadichte ist abhängig vom Schichtsystem und nach welcher Schicht diese Plasmabehandlung erfolgt. Zum Aufstäuben werden an sich bekannte Sputterquellen (Magnetrons) verwendet, die in Durchlauf-Zerstäubungsanlagen mit mehreren Stationen angeordnet sind.

Es hat sich gezeigt, daß diese Plasmabehandlung mittels unipolar oder bipolar gepulstem Magnetron vorteilhaft ist. Bei dem Einsatz eines bekannten Dual-Magnetron-Sputter-Systems ist es möglich, durch eine spezielle Prozeßführung ein Magnetron als Beschichtungsquelle und das zweite Magnetron als Plasmaquelle zu nutzen.

Bei der Plasmabehandlung mittels gepulster Magnetrons hat sich der Frequenzbereich von 10 bis 200 kHz als besonders effektiv erwiesen. Durch den Einsatz unterschiedlicher Stromversorgungen mit unterschiedlichen Pulsformen oder einer sinusförmigen Energieeinspeisung ist eine Optimierung der einzelnen Magnetrons in bezug auf erreichbare Plasmadichte möglich.

Um bei der Verwendung von Magnetrons als Plasmaquellen die nötigen Plasmaintensitäten zu erreichen, ist es besonders vorteilhaft, das Arbeitsgas durch eine Erhöhung des Reaktivgaspartialdruckes zu modifizieren. Dadurch wird das Abstäuben des Targets wesentlich reduziert und es ist möglich, mit bedeutend höheren Plasmadichten zu arbeiten.

Für eine stabile Prozeßführung ist es zweckmäßig, diese Magnetrons in-situ zu überwachen und zu steuern. Für diese in-situ Überwachung kann die Intensität der Plasmaemission, ein elektrischer Parameter der Magnetronentladung oder die Größe des Partialdruckes des Reaktivgases genutzt werden.

Eine weitere Möglichkeit zur Stabilisierung des als Plasmaquelle wirkenden Magnetrons besteht darin, bei konstantem Reaktivgasfluß zu arbeiten.
Beim Einsatz von Dual-Magnetron-Sputter-Systemen hat sich als besonders vorteilhaft erwiesen, bei einem der beiden Magnetrons Titan als Targetmaterial zu verwenden. Die schon geringe Sputterrate von Titan ermöglicht besonders hohe Plasmadichten im Verhältnis zur Abstäuberate. Wird beim zweiten Magnetron, das als Plasmaquelle dient, ein Target aus dem Beschichtungsmaterial des ersten Magnetrons eingesetzt, erfolgt in unmittelbarer Nähe der Beschichtung die zusätzliche Plasmaaktivierung. Dadurch ist es möglich, auf kleinem Raum die Beschichtung mit der Plasmaaktivierung zu kombinieren.
Es ist weiterhin vorteilhaft, daß bei Verwendung eines Dual-Magnetrons die Regelung des Raktivgaseinlasses auf eine konstante Frequenz des Entladungsstromes erfolgt.
Eine weitere vorteilhafte Ausgestaltung besteht darin, daß das Plasma mittels Mikrowelle erzeugt wird. Der Vorteil besteht darin, daß durch den Einsatz derartiger Plasmaquellen sehr hohe Plasmadichten erzielt werden können.

Anhand von zwei Ausführungsbeispielen wird die Erfindung näher erläutert.

Beim ersten Beispiel wird ein wärmereflektierendes Schichtsystem hergestellt, das folgenden Schichtaufbau hat: Glas - ZnO - Ag - Ti - Zn. Das Substrat ist Floatglas.

Die einzelnen Schichten werden durch Zerstäubung mittels Magnetrons aufgebracht. Die einzelnen Schichtdicken betragen dabei für ZnO - 34 nm, für Ag - 9 nm, für Ti - 3 nm und für ZnO - 40 nm.
Die Herstellung des Schichtsystems erfolgt, indem das Floatglas durch die einzelnen Beschichtungsstationen einer Zerstäubungsanlage - mit Magnetrons ausgerüstet - mit einer konstanten Geschwindigkeit transportiert wird. In jeder Station befindet sich mindestens ein Magnetron mit einem Target aus dem jeweiligen Beschichtungsmaterial.
Nach dem Aufstäuben der Ti -Schicht wird eine Plasmabehandlung durchgeführt. Als Plasmaquelle dient ein weiteres Magnetron mit Titantarget mit unipolar gepulster Energieeinspeisung. Das Arbeitsgas für dieses Magnetron besteht aus reinem Sauerstoff. Dieses Magnetron wird mit einer elektrischen Leistung von 30 kW betrieben und der Arbeitsgasdruck beträgt 0,3 Pa.
Bei diesen Betriebsbedingungen beträgt die Beschichtungsrate von Titan nur noch 5% der Sputterrate, die bei Verwendung von reinem Argon als Arbeitsgas erzielt wird. Durch diese geringe Beschichtungsrate werden die optischen Eigenschaften des Schichtsystems nicht verändert. Der ohmsche Flächenwiderstand der beschichteten Glasscheibe wird durch diese Plasmabehandlung auf 5,6 Ohm pro Quadrat reduziert. Bei einer nachträglichen Temperaturbehandlung tritt keine Änderung dieses Flächenwiderstandes ein.
Im Gegensatz zu dem erfindungsgemäßen Verfahren wurde das Glas in bekannter Weise beschichtet. Der Flächenwiderstand des aufgestäubten Schichtsystems beträgt dabei 5,9 Ohm pro Quadrat. Durch eine nachträgliche Temperaturbehandlung konnte dieser Flächenwiderstand auf 5,7 Ohm pro Quadrat reduziert werden. Damit ist bewiesen, daß ohne jede Temperatur-Nachbehandlung bessere Werte für den Flächenwiderstand erreicht werden.

Im zweiten Beispiel wird die Herstellung des gleichen Schichtsystems unter gleichen Betriebsbedingungen bei Verwendung eines Dual-Magnetron-Sputter-Systems beschrieben.
Die Ti-Schicht aus dem ersten Target aus Titan des Magnetron-Systems wird in bekannter Weise aufgestäubt. Das zweite Target ist aus Zink.
Als Arbeitsgas wird ein Argon-Sauerstoff-Gemisch im Verhältnis 1: 5 in die Prozeßkammer eingelassen. Die Energieeinspeisung in das Magnetron-System erfolgte mit Hilfe eines Sinusgenerators derart, daß die Energie auf beide Magnetrons gleichmäßig aufgeteilt ist. Durch diese Betriebsweise wird erreicht, daß das erste Magnetron des Magnetron-Systems mit Titantarget als Plasmaquelle arbeitet und das zweite Magnetron mit Zinktarget zur Schichtbildung dient.
Das nach diesem Verfahren hergestellte Schichtsystem zeigt nach der Beschichtung einen ohmschen Flächenwiderstand von 5,4 Ohm pro Quadrat. Bei einer nachträglichen Temperaturbehandlung trat eine geringfügige Vergrößerung dieses Flächenwiderstandes um ca. 0,1 Ohm pro Quadrat ein.

## Patentansprüche

1. Verfahren zur Herstellung wärmereflektierender Schichtsysteme auf transparenten Substraten durch Sputtern, wobei das Schichtsystem mindestens aus einer dielektrischen Grundschicht, einer Reflektionsschicht, vorzugsweise aus Silber, einer Metall- oder Edelmetallschicht und einer dielektrischen Deckschicht besteht, mittels eines Magnetrons, **dadurch gekennzeichnet, dass** die aufgestäubte Metallschicht, vorzugsweise Edelmetallschicht, mittels eines weiteren Magnetrons, welches in Sauerstoff als Reaktivgas betrieben wird, einer Plasmanachbehandlung unterzogen wird.

2. Verfahren nach Anspruch 1, **dadurch gekennzeichnet, daß** das Plasma mittels eines unipolar betriebenen Magnetrons erzeugt wird.

3. Verfahren nach Anspruch 1, **dadurch gekennzeichnet, daß** die Plasmabehandlung mit Hilfe eines Dual-Magnetron-Sputter-Systems erfolgt.

4. Verfahren nach Anspruch 3, **dadurch gekennzeichnet, daß** bei dem Aufstäuben einer Schicht mit einem Dual-Magnetron-Sputter-System die Plasmabehandlung nur mit einer Katode erfolgt.

5. Verfahren nach Anspruch 1 bis 4, **dadurch gekennzeichnet, daß** die Plasmabehandlung bei reduzierter Zerstäubungsrate erfolgt und die Ratereduzierung durch einen gegenüber der stöchiometrischen Schichtabscheidung erhöhten Partialdruck des Reaktivgases erfolgt.

6. Verfahren nach Anspruch 5, **dadurch gekennzeichnet, daß** die Regelung des Reaktivgaseinlasses auf eine konstante Plasmaemission erfolgt.

7. Verfahren nach Anspruch 5, **dadurch gekennzeichnet, daß** die Regelung des Reaktivgaseinlasses auf eine konstante Brennspannug der Glimmentladung des Magnetrons erfolgt.

8. Verfahren nach Anspruch 5, **dadurch gekennzeichnet, daß** die Regelung des Reaktivgaseinlasses auf einen konstanten Reaktivgaspartialdruck erfolgt.

9. Verfahren nach Anspruch 5, **dadurch gekennzeichnet, daß** die Regelung des Reaktivgaseinlasses auf eine konstante Frequenz des Entladungsstromes erfolgt.

10. Verfahren nach Anspruch 1 bis 9, **dadurch gekennzeichnet, daß** die Plasmabehandlung mittels Mikrowellenplasma erfolgt.

## Claims

1. Process for the production of heat-reflecting coating systems on transparent substrates by sputtering, the coating system at least comprising a dielectric base layer, a reflection layer, preferably comprising silver, a metal or precious metal layer and a dielectric covering layer, by means of a magnetron, **characterized in that** the sputtered metal layer, preferably precious metal layer, is subjected to a subsequent plasma treatment by means of a further magnetron, which is operated in oxygen as reactive gas.

2. Method according to Claim 1, **characterized in that** the plasma is generated by means of a magnetron which is operated in unipolar mode.

3. Method according to Claim 1, **characterized in that** the plasma treatment is carried out with the aid of a dual-magnetron sputtering system.

4. Method according to Claim 3, **characterized in that** during the sputtering of a layer using a dual-magnetron sputtering system, the plasma treatment is carried out only using a cathode,

5. Method according to Claims 1 to 4, **characterized in that** the plasma treatment takes place at a reduced atomization rate, and the reduction in rate is effected by increasing the partial pressure of the reactive gas compared to stoichiometric layer deposition.

6. Method according to Claim 5, **characterized in that** the reactive gas intake is regulated to a constant plasma emission.

7. Method according to Claim 5, **characterized in that** the reactive gas intake is regulated to a constant operating voltage of the glow discharge of the magnetron.

8. Method according to Claim 5, **characterized in that** the reactive gas intake is regulated to a constant reactive gas partial pressure.

9. Method according to Claim 5, **characterized in that** the reactive gas intake is regulated to a constant frequency of the discharge current.

10. Method according to Claims 1 to 9, **characterized in that** the plasma treatment takes place by means of microwave plasma.

## Revendications

1. Procédé pour la production de revêtements réfléchissant le rayonnement thermique sur des substrats transparents par pulvérisation, le revêtement se composant au moins d'une couche de base diélectrique, d'une couche réfléchissante, de préférence en argent, d'une couche en métal ou en métal précieux et d'une couche de recouvrement diélectrique, au moyen d'un magnétron, **caractérisé en ce que** la couche de métal saupoudrée, de préférence la couche de métal précieux, est soumise à un traitement ultérieur au plasma au moyen d'un autre magnétron qui utilise l'oxygène comme gaz réactif.

2. Procédé selon la revendication 1, **caractérisé en ce que** le plasma est produit au moyen d'un magnétron à fonctionnement unipolaire.

3. Procédé selon la revendication 1, **caractérisé en ce que** le traitement au plasma est réalisé à l'aide d'un système de pulvérisation à double magnétron.

4. Procédé selon la revendication 3, **caractérisé en ce que** lors du saupoudrage d'une couche avec un système de pulvérisation à double magnétron, le traitement au plasma s'effectue seulement avec une cathode.

5. Procédé selon les revendications 1 à 4, **caractérisé en ce que** le traitement au plasma s'effectue à un taux de pulvérisation réduit et la réduction du taux est réalisée par une pression partielle du gaz réactif augmentée par rapport à celle de la précipitation de la couche stoechiométrique.

6. Procédé selon la revendication 5, **caractérisé en ce que** la régulation de l'admission du gaz réactif s'effectue à une émission de plasma constante.

7. Procédé selon la revendication 5, **caractérisé en ce que** la régulation de l'admission du gaz réactif s'effectue à une tension de décharge constante de la décharge lumineuse du magnétron.

8. Procédé selon la revendication 5, **caractérisé en ce que** la régulation de l'admission du gaz réactif s'effectue à une pression partielle constante du gaz réactif.

9. Procédé selon la revendication 5, **caractérisé en ce que** la régulation de l'admission du gaz réactif s'effectue à une fréquence constante du courant de décharge.

10. Procédé selon les revendications 1 à 9, **caractérisé en ce que** le traitement au plasma est réalisé par un plasma à hyperfréquences.
